Europäisches Patentamt

European Patent Office

Office européen des brevets

Publication number: **0 290 152**
**A2**

# EUROPEAN PATENT APPLICATION

(21) Application number: **88303401.9**

(22) Date of filing: **15.04.88**

(51) Int. Cl.⁴ **G11C 19/00**

(30) Priority: **24.04.87 US 42403**

(43) Date of publication of application:
**09.11.88 Bulletin 88/45**

(84) Designated Contracting States:
**AT BE CH DE ES FR GB GR IT LI LU NL SE**

(71) Applicant: **ADVANCED MICRO DEVICES, INC.**
**901 Thompson Place P.O. Box 3453**
**Sunnyvale, CA 94088(US)**

(72) Inventor: **New, Bernard J.**
**142 Stacia Street**
**Los Gatos California 95030(US)**

(74) Representative: **Sanders, Peter Colin**
**Christopher et al**
**BROOKES & MARTIN High Holborn House**
**52/54 High Holborn**
**London WC1V 6SE(GB)**

(54) **Pipeline register with feed through.**

(57) An integrated circuit device (10) is provided
which comprises first circuitry (16) for receiving re-
spective first digital signals (12) and for providing a
plurality of respective first delayed digital signal representations (64-1 - 64-7) of the respective first
digital signals, said first circuitry being adapted for
respectively providing the respective first delayed
digital signal representations at prescribed intervals
of time; and second circuitry (22) for receiving the
respective first digital signals (12) and the plurality of
respective first delayed digital signal representations
(64-1 - 64-7) and for selecting between the respective first digital signals and respective first delayed
digital signals and respective first delayed digital
signal representations to provide respective selected
second digital signals (14).

EP 0 290 152 A2

Xerox Copy Centre

## PIPELINE REGISTER WITH FEED THROUGH

The invention relates generally to integrated circuit devices and more particularly to integrated circuit devices including means for delaying the provision of digital signals for any one or more of a plurality of prescribed intervals of time.

In complex electronic systems, there frequently is a need for integrated circuit devices adapted to delay the provision of digital signals such as 8-bit digital data signals by one or more of a plurality of prescribed intervals of time.

Devices for accomplishing this task are well known. One such device is the Am29520A multilevel pipeline register which is produced by Advanced Micro Devices. Inc. having a place of business at 901 Thompson Place in Sunnyvale, California. It is adapted to cascade 8-bit wide digital data signals through one or more of a series of four registers coupled to form a register pipeline. The length of the time delay between the time when digital data signals are provided to an Am29520A device and the time when the digital data signals are read out from the device can be selectively varied by prescribed intervals of time. For example, the length of the time interval can be varied by changing the number of registers in the pipeline register through which the digital data signals are cascaded before being read out from the device.

While earlier devices such as the Am29520A generally have been successful, there have been shortcomings with their use. Such devices typically are inserted as components in electronic systems in order to delay the provision of digital signals within the system. At times, however, it is desirable for the digital signals to be provided within the system substantially without delay. Unfortunately, earlier devices of the type described above are not suited for providing the digital signals substantially without delay.

Thus, there exists a need for an integrated circuit device suitable for delaying the provision of digital signals by any one or more of a plurality of prescribed intervals of time and, alternatively, for providing the digital signals substantially without delay. The present invention meets this need.

In particular, there is described herein an integrated circuit device which includes first integrated circuitry for receiving respective first digital signals and for providing a plurality of respective first delayed digital signal representations of the respective first digital signals. The first circuitry is adapted for respectively providing the respective first delayed digital signal representations at prescribed intervals of time. The device also includes circuitry for receiving the respective first digital signals and the plurality of respective first delayed digital signal representations and for selecting between the respective first digital signals and respective first delayed digital signal representations to provide respective selected second digital signals. The device alternatively either directly feeds through the first digital signals and provides them as the second digital signals or delays the first digital signals before providing them as the second digital signals. The device thereby provides added flexibility in a system in which it is used.

In the accompanying drawings, by way of example only:-

Fig. 1 is a block diagram of an integrated circuit device embodying the present invention;

Fig. 2 is a chart illustrating the operation of the device of Fig. 1; and

Fig. 3 is a chart further illustrating the operation of the device of Fig. 1.

The drawings illustrate a novel integrated circuit device for receiving digital electronic signals and for delaying the provision of the signals for any one or more of a plurality of prescribed intervals of time, and alternatively for providing the signals without delay. The following description is presented to enable any person skilled in the art to make and use the illustrated device, and is provided in the context of a particular application and its requirements. Various modifications will be apparent to those skilled in the art.

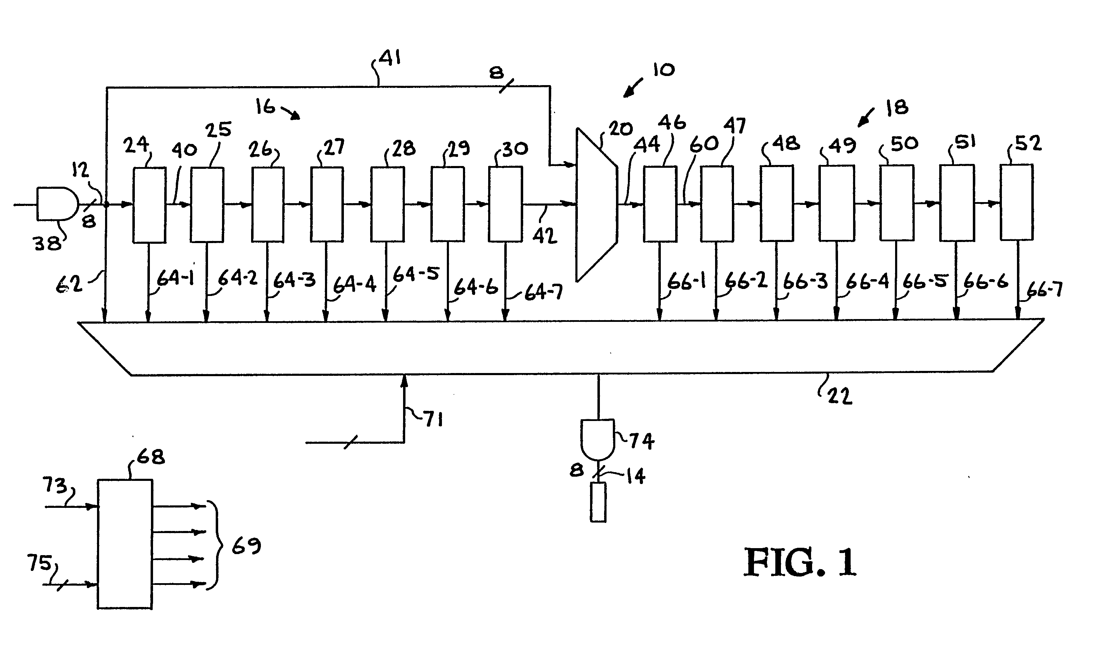

Referring to Fig. 1, there is shown an integrated circuit device 10 coupled to receive on lines 12 first 8-bit digital signals and to provide on lines 14 corresponding second 8-bit digital signals. The device 10 includes respective first and second register pipelines 16 and 18 as well as respective first and second multiplexer circuits 20 and 22.

As explained below, the device 10 can be configured so as to immediately feed through the first digital signals on lines 12 for provision on lines 14 as the second digital signals. Alternatively, the first digital signals can be delayed before their provision on lines 14 as second digital signals.

The first register pipeline 16 includes seven registers respectively labelled with reference numerals 24-30. Register 24 is coupled to receive the first digital data signals provided on lines 12 by buffer circuit 38. Upon the provision of a first clock pulse signal, register 24 can provide respective first delayed digital signal representations of the first digital signals on lines 40 as explained more fully below. A first series of registers 25-30 are coupled as shown to receive the first delayed digital signal representations provided on lines 40 and to successively transfer the delayed first digital signal representations to consecutive registers in the first series. For example, upon the provision of a second clock pulse, register 25 can provide first delayed digital signal representations to register 26. Upon the provision of a subsequent clock pulse, register 26 can provide the delayed first digital signal representations to register 27, and so on until the delayed digital signal representations reach register 30.

The first multiplexer circuit 20 is coupled for receiving on lines 41 the first digital signals and for receiving on lines 42 first delayed digital signal representations provided by register 30. The first multiplexer circuit 20 selects between respective first 8-bit digital signals and respective delayed first 8-bit digital signal representations and provides on lines 44 selected third 8-bit digital signals to the second register pipeline 18. It will be appreciated that the third digital signals either comprise first digital signals provided without delay on lines 41 or delayed first digital signal representations provided on lines 42, depending upon the selection by the first multiplexer circuit.

The second register pipeline 18 comprises seven registers respectively labelled with reference numerals 46-52. Register 46 is coupled to receive the respective third digital signals provided on lines 44. Upon the provision of a clock pulse signal, register 46 can provide on lines 60 respective second delayed digital signal representations. A second series of registers 47-52 are coupled as shown to receive the second delayed digital signal representations provided on lines 60 and to successively transfer the delayed second digital signal representations to consecutive registers in the second series. For example, upon the provision of a later clock pulse, register 46 can provide second delayed digital signal representations to register 47. Upon the provision of an even later clock pulse, register 47, in turn, can provide the delayed second digital signal representations to register 48, and so on until the delayed digital signal representations reach register 52.

The second multiplexer circuit 22 is coupled for receiving the first 8-bit digital signals on lines 62 and for receiving respective delayed first 8-bit digital signal representations on respective lines 64-1 through 64-7 and for receiving respective delayed second 8-bit digital signal representations on respective lines 66-1 through 66-7. The second multiplexer circuit 22 selects between the first digital signals and the respective first and second delayed digital signal representations and provides the selected second digital signals to buffer circuit 74 for provision on lines 14. It will be appreciated from the discussion above that both the first delayed digital signal representations and the second delayed digital signal representations comprise delayed representations of respective first digital signals provided previously on lines 12.

In operation, a series of first 8-bit digital signals can be provided to the device 10 via lines 12. In response to first control signals ($I_1$, $I_0$) on lines 75 and clock pulse signals on line 73, as explained below, instruction decode circuitry 68 provides on lines 69 first control signals which control the transfer of respective first and second digital signal representations from register-to-register through the respective first and second register pipelines 16 and 18. Second control signals ($S_3$, $S_2$, $S_1$, $S_0$) provided on lines 71, as explained below, control the selection by the second multiplexer 22 of signals to be provided on lines 14.

The delay feature of the device 10 will be easily understood by those skilled in the art. For example, since it requires at least three clock pulses for first 8-bit signal representations to be transferred from register 24 to register 27, the 8-bit digital signals provided by register 27 on lines 64-4 in fact are delayed signal representations of the 8-bit digital signals provided on lines 12. The length of the time delay between the provision of first 8-bit digital signals on lines 12 and the provision of the delayed first digital signal representations of these same signals on lines 64-4 can be prescribed in part by the duration of time between consecutive clock pulse signals provided on line 73 to the instruction decode circuitry 68.

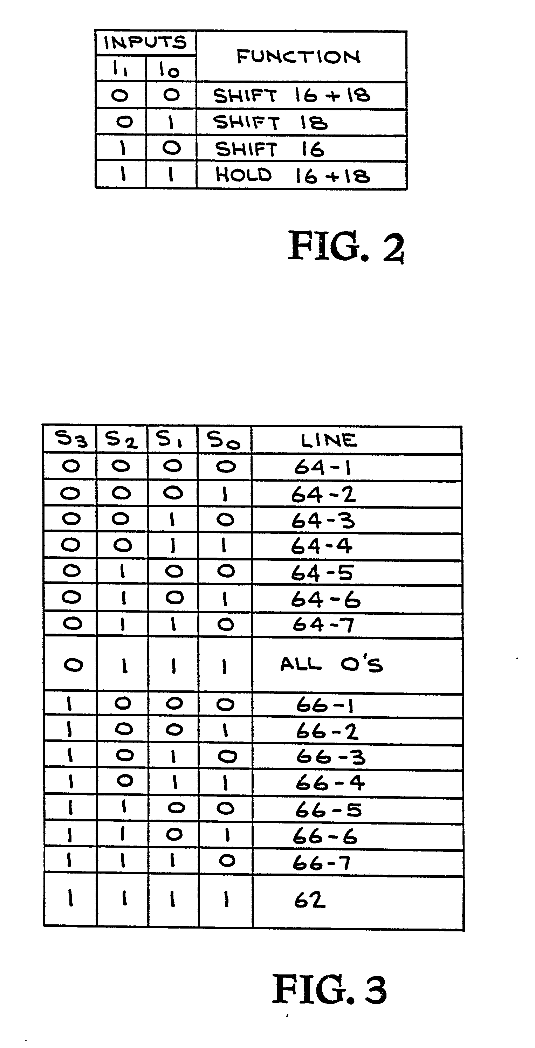

The operation of the integrated circuit device 10 of FIG. 1 can be further appreciated from the charts of FIGS. 2 and 3 in conjunction with the corresponding explanation below. Referring to FIG. 2, there is provided a chart showing the function performed by the respective first and second register pipelines 16, 18 and the first multiplexer circuit 20 in response to four combinations of first control signals ($I_1$, $I_0$) provided to the instruction decode circuitry 68. For example, in response to a first control signal sequence on lines 75 of logical (0, 0), each register in the first register pipeline 16 is caused to provide the respective first delayed digital signal representations stored by it to the next consecutive register in the pipeline 16; the first multiplexer circuit 20 is caused to select the respective first delayed digital signal representations on lines 42 and to provide those signals as the selected third digital signals on lines 44; each respective register in the second register pipeline 18 similarly is caused to provide the respective second delayed digital signal representations stored by it to the next consecutive register in pipeline 18; the previous contents of register 52 are simply written over and lost.

In response to a first control signal sequence of logical (0,1), the contents of each respective register in the first register pipeline 16 are held constant; while each respective register in the second register pipeline 18 is caused to provide the respective second delayed digital signal representations stored by it to the next consecutive register in the pipeline 18.

In response to a first control signal sequence of logical (1,0), the contents of each respective register in the second register pipeline 18 are held constant; while each respective register in the first register pipeline 16 is caused to provide the respective second delayed digital signal representations stored by it to the next consecutive register in the pipeline 16.

In response to a first control signal sequence of logical (0,0), each respective register in both the respective first and second register pipelines 16 and 18 are held constant.

Referring to the FIG. 3, there is a chart which summarizes the selection function performed by the second multiplexer circuit 22 in response to the second control signals ($S_3$, $S_2$, $S_1$, $S_0$). For example, in response to a second control signal sequence of (0,1,0,0), the first delayed digital signal representations provided on lines 64-5 by register 28 are selected for provision on lines 14 as the second digital signals. In response to a second control signal sequence of (1,1,1,1), the first digital signals on lines 62 are fed directly through the second multiplexer circuit 22 for provision on lines 14. In response to a second control signal sequence of (0,1,1,1), the second digital signals provided on lines 14 are all held constant at logical 0 because the second control signal sequence is essentially an extra set of control signals.

Therefore, it will be appreciated that by providing appropriate combinations of respective first and second control signals, the device 10 advantageously can delay the provision of first digital signals on lines 12 by prescribed intervals of time before providing them on lines 14 as second digital signals. Alternatively, the device 10 can provide first digital signals on lines 12 immediately to lines 14 for provision as second digital signals. Thus, device 10 selectively can be used to provide feed through only after a prescribed interval of time or to provide direct and immediate feed through without delay.

It will be understood that the above-described embodiment is merely illustrative of many possible embodiments. Numerous and varied other arrangements can readily be devised within the scope of the appended claims.

## Claims

1. An integrated circuit device comprising:

first means (16) for receiving respective first digital signals (12) and a plurality of respective first delayed digital signal representations (64-1 - 64-7) of the respective first digital signals, said first means being adapted for respectively providing the respective first delayed digital signal representations at prescribed intervals of time; and

second means (22) for receiving the respective first digital signals (62) and the plurality of respective first delayed digital signal representations (64-1 - 64-7) and for selecting between the respective first digital signals and respective first delayed digital signal representations to provide respective selected second digital signals (14).

2. The device of Claim 1 wherein said first means includes a plurality of registers (24-30).

3. The device of Claim 2 wherein said plurality of registers (24-30) are coupled to form a first register pipeline means (16) for receiving the respective first digital signals (12) and for providing the plurality of respective first delayed digital signal representations (64-1 - 64-7).

4. The device of Claim 3 wherein said plurality of registers (24-30) of said first register pipeline means (16) are coupled for successively transferring respective first delayed digital signal representations (64-1 - 64-7) to consecutive registers (24-30) of said first register pipeline means (16).

5. An integrated circuit device comprising:

first register pipeline means (16) for receiving respective first digital signals (12) and for providing a plurality of respective first delayed digital signal representations (64-1 - 64-7) of the respective first digital signals (12), said first register pipeline means (16) including at least one first register (24) coupled for receiving respective first digital signals (12) and for providing respective first delayed digital signal representations (40) to a first series of consecutive respective registers (25-30) coupled for successively transferring the first delayed digital signal representations to consecutive registers of the first series; and

second means (22) for receiving the respective first digital signals (62) and the plurality of respective first delayed digital signal representations (64-1 - 64-7) and for selecting between the respective first digital signals and respective first delayed digital signal representations to provide respective selected second digital signals (14).

6. The device of Claim 5 and further comprising:

third means (20) for receiving respective first digital signals (41) and for receiving respective first delayed digital signal representations (42) from the plurality (64-1 - 64-7) and for selecting between the respective first digital signals and respective first delayed digital signal representations to provide respective selected third digital signals (44); and

second register pipeline means (18) for receiving the respective third digital signals (44) and for providing a plurality of respective second delayed digital signal representations (66-1 - 66-7) of the respective first digital signals (12), said second register pipeline means including at least one second register (46) coupled for receiving the respective third digital signals and for providing respective second delayed digital signal representations (60) to a second series of consecutive respective registers (47-52) coupled for successively transferring second delayed digital signal representations to consecutive registers of the second series.

FIG. 1

| INPUTS | | FUNCTION |
|--------|--------|----------|
| $I_1$ | $I_0$ | |
| O | O | SHIFT 16 + 18 |
| O | 1 | SHIFT 18 |
| 1 | O | SHIFT 16 |
| 1 | 1 | HOLD 16 + 18 |

# FIG. 2

| $S_3$ | $S_2$ | $S_1$ | $S_0$ | LINE |
|-------|-------|-------|-------|------|
| O | O | O | O | 64-1 |
| O | O | O | 1 | 64-2 |
| O | O | 1 | O | 64-3 |
| O | O | 1 | 1 | 64-4 |
| O | 1 | O | O | 64-5 |
| O | 1 | O | 1 | 64-6 |
| O | 1 | 1 | O | 64-7 |
| O | 1 | 1 | 1 | ALL O'S |
| 1 | O | O | O | 66-1 |
| 1 | O | O | 1 | 66-2 |
| 1 | O | 1 | O | 66-3 |
| 1 | O | 1 | 1 | 66-4 |
| 1 | 1 | O | O | 66-5 |
| 1 | 1 | O | 1 | 66-6 |
| 1 | 1 | 1 | O | 66-7 |
| 1 | 1 | 1 | 1 | 62 |

# FIG. 3